(19) Europäisches Patentamt
European Patent Office
Office européen des brevets

(11) **EP 2 400 573 A1**

(12) **EUROPÄISCHE PATENTANMELDUNG**

(43) Veröffentlichungstag:
 **28.12.2011  Patentblatt 2011/52**

(51) Int Cl.:
 *H01L 41/08* (2006.01)     *H01L 41/26* (2006.01)
 *H01L 41/113* (2006.01)     *H01L 41/193* (2006.01)

(21) Anmeldenummer: **10167012.3**

(22) Anmeldetag: **23.06.2010**

(84) Benannte Vertragsstaaten:
 **AL AT BE BG CH CY CZ DE DK EE ES FI FR GB
 GR HR HU IE IS IT LI LT LU LV MC MK MT NL NO
 PL PT RO SE SI SK SM TR**
 Benannte Erstreckungsstaaten:
 **BA ME RS**

(71) Anmelder: **Bayer MaterialScience AG
 51368 Leverkusen (DE)**

(72) Erfinder: **Die Erfindernennung liegt noch nicht vor**

(54) **Elektromechanischer Wandler, Verfahren zu dessen Herstellung und Verwendung desselben**

(57)  Ein elektromechanischer Wandler umfasst mindestens eine dielektrische Elastomerschicht (1), mindestens eine Elektretschicht (4,5), und zwei Elektroden (2,3), wobei die dielektrische Elastomerschicht (1) von der wenigstens einen Elektretschicht (4) kontaktiert wird, die wenigstens eine Elektretschicht (4) eine elektrische Ladung trägt und von einer ersten Elektrode (2) kontaktiert wird und auf der der ersten Elektrode (2) gegenüberliegenden Seite der dielektrischen Elastomerschicht (1) eine zweite Elektrode (3) angeordnet ist. Die Erfindung betrifft weiterhin ein Verfahren zur Herstellung eines solchen Wandlers, dessen Verwendung und die Gewinnung von elektrischer Energie, in dem der erfindungsgemäße Wandler eingesetzt werden kann. Ein Betrieb des Wandlers zur Energiegewinnung im planaren Modus ($d_{31}$-Mode) ist möglich.

FIG. 5

**Beschreibung**

Die vorliegende Erfindung betrifft einen elektromechanischen Wandler. Sie betrifft weiterhin ein Verfahren zu dessen Herstellung und dessen Verwendung. Weiterhin betrifft die Erfindung ein Verfahren zur Gewinnung von elektrischer Energie, in dem der erfindungsgemäße Wandler eingesetzt werden kann.

Elektromechanische Wandler wandeln elektrische Energie in mechanische Energie um und umgekehrt. Sie können als Bestandteil von Sensoren, Aktuatoren und Generatoren eingesetzt werden. WO 2001/06575 A1 offenbart beispielsweise einen Energieumwandler, seine Verwendung sowie seine Herstellung. Der Energieumwandler wandelt mechanische Energie in elektrische Energie um. Einige der gezeigten Energieumwandler weisen vorgespannte Polymere auf. Die Vorspannung verbessert die Umwandlung zwischen elektrischer und mechanischer Energie. Darüber hinaus wird eine Vorrichtung offenbart, welche ein elektroaktives Polymer zur Umwandlung von elektrischer Energie in mechanische Energie umfasst. Des Weiteren werden Elektroden offenbart, welche an die Form des Polymers in dem Energieumwandler angepasst sind. Auch werden Verfahren zur Herstellung einer elektromechanischen Vorrichtung offenbart, welche ein oder mehrere elektroaktive Polymere umfasst.

Der Einsatz von Ferroelektret-Materialien und insbesondere von Polymer-Ferroelektreten ist bislang nur im sogenannten Dickenmodus ($d_{33}$-Mode) beschrieben worden. Wegen der theoretisch erreichbaren viel größeren Dehnung wäre jedoch auch ein Betrieb im planaren Modus ($d_{31}$-Mode) wünschenswert. Von Interesse wäre ein solcher Betrieb vor allem im Bereich der Energiegewinnung.

In dem Konferenzbeitrag "Three-layer ferroelectrets from perforated Teflon®-PFTE films fused between two homogenous Teflon®-FEP films", 2007 Annual Report Conference on Electrical Insulation and Dielectric Phenomena von H. C. Basso, R. A. P. Altafim, R. A. C. Altafim, A. Mellinger, Peng Fang, W. Wirges und R. Gerhard wird ein Weg zu polymeren Ferroelektreten mit gleichförmigen Hohlräumen beschrieben. Zwei homogene Teflon®-FEP-Filme werden mittels eines an sie thermisch gebundenen Teflon®-PTFE-Films voneinander getrennt. Der Teflon®-PTFE-Film weist mehrere homogene Löcher auf. So werden geschlossene Hohlräume mit FEP-Boden und Deckel und PTFE-Wänden gebildet.

Nach dem Aufladen der oberen und unteren FEP-Schichten mit positiver beziehungsweise negativer Polarität bilden die Hohlräume große Dipole, die durch mechanische oder elektrische Einwirkung verformt werden können. Als Folge dessen zeigt der Dreischicht-Sandwich direkte und inverse Piezoelektrizität. Das kontinuierliche Verfahren zum Verbinden der Schichten beinhaltet eine Presse mit beheizten Zylinderrollen, die bei Temperaturen von bis zu 310 °C betrieben werden. Dieses ermöglicht die Herstellung von kostengünstigen Wandlermaterialien im großen Maßstab. Der Konferenzbeitrag behandelt das Konzept, die Verarbeitung, das Aufladen und die elektromechanischen Eigenschaften der Dreischicht-Ferroelektrete.

Schichtenverbunde aus dielektrischen Elastomeren und anderen Materialien für elektromechanische Wandler werden in US 2009/0169829 A1 offenbart. Diese Patentanmeldung beschäftigt sich mit einem Mehrschichtverbund mit einem Film, einer ersten elektrisch leitfähigen Schicht und wenigstens einer Zwischenschicht, die zwischen dem Film und der ersten elektrisch leitfähigen Schicht angeordnet ist. Der Film ist aus einem dielektrischen Material gemacht und weist eine erste und zweite Oberfläche auf. Wenigstens die erste Oberfläche umfasst ein Oberflächenmuster mit Erhöhungen und Vertiefungen. Die erste elektrisch leitfähige Schicht ist auf dem Oberflächenmuster angebracht und weist eine Wellenform auf, die durch das Oberflächenmuster des Films gebildet wird.

Gemäß einer Ausführungsform der in dieser Patentanmeldung beschriebenen Erfindung kann die Zwischenschicht durch Plasmabehandlung der Filmoberfläche erhalten werden. Dabei dient die Zwischenschicht der Verbesserung der Haftung zwischen der elektrisch leitfähigen Schicht und dem Film dient.

Eine bestimmte Kombination von elektroaktiven Polymeren und piezoelektrischen Polymeren ist Gegenstand der internationalen Patentanmeldung WO 2008/076271 A2. Hierin wird ein integrierter Sensor-Aktor beschrieben, der ein elektroaktives Polymer verwendet. Der Sensor-Aktor umfasst einen Aktorteil aus einem ionischen Polymer-Metall-Verbund, einen Sensorteil aus einem piezoelektrischen Material und einen Isolierteil zwischen dem Aktorteil und dem Sensorteil. Der Sensor-Aktor kann weiterhin einen Ausgleichsschaltkreis zum Empfangen eines Sensorsignals von dem Sensorteil und eines Aktorsignals von dem Aktorteil aufweisen, der das empfangene Signal zur Kopplung zwischen dem Aktorteil und dem Sensorteil kompensiert. Der hier offenbarte Aufbau eignet sich jedoch nicht zum energiegewinnenden Betrieb in der Flächenrichtung des Elements.

Der vorliegenden Erfindung liegt die Aufgabe zugrunde, einen elektromechanischen Wandler der eingangs genannten Art anzugeben, der sich durch die Möglichkeit des Betriebes bei größeren Dehnungen insbesondere in der Flächenrichtung auszeichnet.

Die Aufgabe wird erfindungsgemäß dadurch gelöst, dass der Wandler mindestens eine dielektrische Elastomerschicht, Elektroden sowie mindestens eine Elektretschicht umfasst, wobei die dielektrische Elastomerschicht von der wenigstens einen Elektretschicht kontaktiert wird, wobei die wenigstens eine Elektretschicht eine elektrische Ladung trägt und von einer ersten Elektrode kontaktiert wird und wobei auf der der ersten Elektrode gegenüberliegenden Seite der dielektrischen Elastomerschicht eine zweite Elektrode angeordnet ist.

Der erfindungsgemäße elektromechanische Wandler basiert zunächst auf der allgemeinen Erkenntnis, dass die für den Betrieb eines solchen Wandlers maßgebliche dielektrische Verschiebung (elektrische Flussdichte) sich durch die Variation zweier Parameter ändern lässt. Die dielektrische Verschiebung lässt sich als die Summe der Polarisation und des Produktes der elektrischen Feldstärke mit der elektrischen Feldkonstante angeben:

$$\vec{D} = \varepsilon_0 \vec{E} + \vec{P}$$

Dass die zweite Elektrode auf der der ersten Elektrode gegenüberliegenden Seite der dielektrischen Elastomerschicht angeordnet ist, kann bedeuten, dass die Elastomerschicht mit dieser Elektrode kontaktiert ist. Es ist aber auch möglich, dass eine Elektretschicht oder andere Schichten zwischen Elektrode und Elastomerschicht sich befinden.

Durch eine Dehnung oder Stauchung des Wandlers in Längs- oder Flächenrichtung kommt es zu einer Änderung der elektrischen Feldkonstante und/oder der Polarisation des Systems. Somit ist ein Betrieb des Wandlers zur Energiegewinnung im planaren Modus ($d_{31}$-Mode) möglich.

Im Vergleich zu piezoelektrischen Wandlern, die im planaren Modus betrieben werden und bei denen Auslenkungen im Promillebereich zu verzeichnen sind, lässt sich der erfindungsgemäße Wandler bei weitaus größeren Dehnungen betreiben. So sind maximale Dehnungen während des Betriebs von > 10%, ≥20%, ≥ 30% oder sogar ≥ 50% denkbar. Auf diese Weise gewinnt man beispielsweise neue Möglichkeiten zur Konstruktion von effizienteren elektromechanischen Wandlern.

Das dielektrische Elastomer kann beispielsweise eine maximale Spannung von ≥ 0,2 MPa und eine maximale Dehnung von ≥ 100 % aufweisen. Im Gebrauchsdehnungsbereich bis ≤ 200 % kann die Spannung von ≥ 0,1 MPa bis ≤ 50 MPa betragen (Bestimmung nach ASTM D 412). Ferner kann das Elastomer ein Elastizitätsmodul bei einer Dehnung von 100 % von ≥ 0,1 MPa bis ≤ 100 MPa aufweisen (Bestimmung nach ASTM D 412).

Es ist möglich, dass die Elastomerschicht und/oder die Elektretschicht oder Elektretschichten kompakt ausgeführt sind. Hierunter ist im Rahmen der vorliegenden Erfindung zu verstehen, dass der Anteil an Hohlräumen innerhalb der jeweiligen Schichten ≥ 0 Volumen-% bis ≤ 5 Volumen-% und insbesondere ≥ 0 Volumen-% bis ≤ 1 Volumen-% beträgt.

Es ist weiterhin bevorzugt, dass die Elastomerschicht und die Elektretschicht oder Elektretschichten flächig miteinander verbunden sind. Die Art der Verbindung kann insbesondere eine stoffschlüssige Verbindung sein.

Die Art der Kontaktierung der Elektretschicht oder Elektretschichten mit ihren zugeordneten Elektroden ist zunächst nicht weiter festgelegt und kann beispielsweise seitlich oder flächig erfolgen. Wenn die dielektrische Elastomerschicht auf sich gegenüberliegenden Seiten von einer Elektretschicht kontaktiert ist, werden jeweils der dielektrischen Elastomerschicht zugewandte und abgewandte Seiten dieser Elektretschicht gebildet. Es ist bevorzugt, dass die erste Elektretschicht auf ihrer der dielektrischen Elastomerschicht abgewandten Seite von der ersten Elektrode kontaktiert ist.

Die Elektroden können weiterhin strukturiert sein. Eine strukturierte Elektrode kann beispielsweise als leitende Beschichtung in Streifen oder in Gitterform ausgestaltet sein. Hierdurch kann zusätzlich die Sensitivität des elektromechanischen Wandlers beeinflusst und auf bestimmte Anwendungen angepasst werden. So können die Elektroden derart strukturiert sein, dass der Wandler aktive und passive Bereiche aufweist. Insbesondere können die Elektroden derart strukturiert sein, dass Signale ortsaufgelöst detektiert oder aktive Bereiche gezielt angesteuert werden können. Dieses kann dadurch erzielt werden, dass die aktiven Bereiche mit Elektroden versehen sind, wogegen die passiven Bereiche keine Elektroden aufweisen.

Die Dicke der dielektrischen Elastomerschicht kann zum Beispiel in einem Bereich von ≥ 10 $\mu$m bis ≤ 500 $\mu$m und vorzugsweise ≥ 20 $\mu$m bis ≤ 200 $\mu$m liegen. Die Dicke der ersten und/oder weiterer Elektretschichten kann beispielsweise in einem Bereich von ≥ 1 $\mu$m bis ≤ 200 $\mu$m und vorzugsweise ≥ 2 $\mu$m bis ≤ 100 $\mu$m liegen.

Ausführungsformen der Erfindung werden nachfolgend geschildert, wobei die einzelnen Ausführungsformen in beliebiger Weise miteinander kombiniert werden können, sofern sich nicht aus dem Zusammenhang eindeutig etwas anderes ergibt.

In einer Ausführungsform des erfindungsgemäßen elektromechanischen Wandlers ist die dielektrische Elastomerschicht auf sich gegenüberliegenden Seiten von einer ersten Elektretschicht und einer zweiten Elektretschicht kontaktiert, wobei die erste Elektretschicht und die zweite Elektretschicht einander entgegengesetzte elektrische Ladungen tragen und wobei die erste Elektretschicht von der ersten Elektrode und die zweite Elektretschicht von der zweiten Elektrode kontaktiert werden.

Durch eine Dehnung oder Stauchung des Wandlers in Längs- oder Flächenrichtung kommt es zu einer Annäherung oder Entfernung der beiden unterschiedlich geladenen Elektretschichten. Somit ist ein Betrieb des Wandlers zur Energiegewinnung im planaren Modus ($d_{31}$-Mode) möglich.

In einer weiteren Ausführungsform des erfindungsgemäßen elektromechanischen Wandlers weist wenigstens eine der Seiten der dielektrischen Elastomerschicht entlang wenigstens einer Richtung ein wellenförmiges Querschnittsprofil mit Erhebungen und Vertiefungen auf.

Vorzugsweise handelt es sich dabei um wenigstens eine der von der ersten und/oder, falls vorhanden, zweiten Elektretschicht kontaktierten Seiten der dielektrischen Elastomerschicht, die entlang wenigstens einer Richtung ein wellenförmiges Querschnittsprofil mit Erhebungen und Vertiefungen aufweist.

Unter "wellenförmig" ist hierbei eine regelmäßige oder unregelmäßige Abfolge von Erhebungen und Vertiefungen zu verstehen. Bevorzugt ist hierbei eine regelmäßige Abfolge. Der Abstand von einer Erhebung zur benachbarten Erhebung kann beispielsweise ≥ 1 μm bis ≤5000 μm und vorzugsweise ≥ 5 μm bis ≤ 2000 μm betragen. Der vertikale Abstand zwischen dem tiefsten Punkt einer Vertiefung und dem höchsten Punkt einer benachbarten Erhöhung kann beispielsweise ≥ 0,3 μm bis ≤ 5000 μm und vorzugsweise ≥ 5 μm bis ≤ 2000 μm betragen.

Ein Beispiel für ein wellenförmiges Profil entlang einer Richtung ist, wenn in einer Elastomerschicht, die eine Dickenrichtung, eine Längsrichtung und eine Querrichtung aufweist, das wellenförmige Profil nur in Längsrichtung gebildet wird. Ein weiteres Beispiel ist der Fall, dass dieses Profil in Längs- und in Querrichtung auftritt.

Der Vorteil eines wellenförmigen Profils liegt darin, dass bei einer Dehnung der Elastomerschicht in Richtung der Wellen mehr Material für die Ausdehnung zur Verfügung steht.

Es ist günstig, wenn das wellenförmige Profil der Seite der dielektrischen Elastomerschicht ein Sinuswellenprofil oder ein Dreieckwellenprofil ist. Diese Wellenformen sind hier so zu verstehen, dass beliebige in der Höhe und/oder Breite skalierte Sinus- oder Dreieckswellen zum Einsatz kommen können. Bevorzugt sind jedoch Sinuswellen, die der Beziehung y = sin(x) gehorchen sowie Dreieckswellen, bei denen die Spitze des Dreiecks einen rechten Winkel bildet.

In einer weiteren Ausführungsform des erfindungsgemäßen elektromechanischen Wandlers weisen die von der wenigstens einen Elektretschicht kontaktierte Seite und die dieser Seite gegenüberliegende Seite der dielektrischen Elastomerschicht entlang derselben Richtung ein wellenförmiges Querschnittsprofil mit Erhebungen und Vertiefungen auf und es verlaufen weiterhin Erhebungen und Vertiefungen des Profils der einen Seite parallel zu Erhebungen und Vertiefungen des Profils der anderen Seite der dielektrischen Elastomerschicht. Dann kann auch bei einer großen Dehnung die Dicke der Elastomerschicht in der Verlaufsrichtung der Wellen möglichst einheitlich bleiben.

In einer weiteren Ausführungsform des erfindungsgemäßen elektromechanischen Wandlers weisen die wenigstens eine Elektretschicht und/oder mindestens die erste Elektrode entlang wenigstens einer Richtung ein wellenförmiges Querschnittsprofil auf, welches an das wellenförmige Querschnittsprofil der kontaktierten Seite der dielektrischen Elastomerschicht angepasst ist. Auf diese Weise können sich Elektret- und/oder Elektrodenschichten auch der Dehnung der Elastomerschicht gut anpassen.

In einer weiteren Ausführungsform des erfindungsgemäßen elektromechanischen Wandlers umfasst die dielektrische Elastomerschicht ein Polyurethanpolymer, Silikonpolymer und/oder Acrylatpolymer. Bevorzugt sind hierbei Polyurethan-Elastomere. Diese können durch Umsetzung eines Polyisocyanats A) und/oder eines Polyisocyanat-Prepolymers B) mit mindestens einer difunktionellen, gegenüber Isocyanatgruppen reaktiven Verbindung C) in Anwesenheit eines in der Polyurethanchemie üblichen Katalysators D) hergestellt werden.

Als Polyisocyanat A) eignen sich beispielsweise 1,4-Butylendiisocyanat, 1,6-Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'- und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanatomethyl) benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Uretdion-, Isocyanurat-, Biuret-, Iminooxadiazindion- oder Oxadiazintrionstruktur enthaltende Verbindungen basierend auf den genannten Diisocyanaten geeignete Bausteine der Komponente A).

Vorzugsweise kann die Komponente A) ein Polyisocyanat oder ein Polyisocyanatgemisch mit einer mittleren NCO-Funktionalität von 2 bis 4 mit ausschließlich aliphatisch oder cycloaliphatisch gebundenen Isocyanatgruppen sein. Bevorzugt handelt es sich um Polyisocyanate oder Polyisocyanatgemische der vorstehend genannten Art mit Uretdion-, Isocyanurat-, Biuret-, Iminooxadiazindion- oder Oxadiazintrionstruktur sowie Mischungen daraus und einer mittleren NCO-Funktionalität der Mischung von 2 bis 4, bevorzugt von 2 bis 2,6 und besonders bevorzugt von 2 bis 2,4.

Die als Komponente B) einsetzbaren Polyisocyanat-Prepolymere können durch Umsetzung von einem oder mehreren Diisocyanaten mit einem oder mehreren hydroxyfunktionellen, insbesondere polymeren, Polyolen gegebenenfalls unter Zusatz von Katalysatoren sowie Hilfs- und Zusatzstoffen erhalten werden. Des Weiteren können zusätzlich Komponenten zur Kettenverlängerung, wie beispielsweise mit primären und/oder sekundären Aminogruppen ($NH_2$- und/oder NH-funktionelle Komponenten) für die Bildung des Polyisocyanat-Prepolymers eingesetzt werden.

Das Polyisocyanat-Prepolymer als Komponente B) kann bevorzugt aus der Umsetzung von polymeren Polyolen und aliphatischen Diisocyanaten erhältlich sein. Hydroxyfunktionelle, polymere Polyole für die Umsetzung zum Polyisocyanat-Prepolymer B) können beispielsweise Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und/oder Polyesterpolycarbonatpolyole sein. Diese können zur Herstellung des Polyisocyanat-Prepolymers einzeln oder in beliebigen Mischungen untereinander eingesetzt werden.

Geeignete Polyesterpolyole zur Herstellung der Polyisocyanat-Prepolymere B) können Polykondensate aus Di- sowie gegebenenfalls Tri- und Tetraolen und Di- sowie gegebenenfalls Tri- und Tetracarbonsäuren oder Hydroxycarbonsäuren oder Lactonen sein. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Beispiele für geeignete Diole sind dabei Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester oder Mischungen davon, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimethylolbenzol oder Trishydroxyethylisocyanurat oder Mischungen davon eingesetzt werden.

Als Dicarbonsäuren können dabei Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dirnethylbernsteinsäure eingesetzt werden. Als Säurequelle können auch die entsprechenden Anhydride verwendet werden.

Sofern die mittlere Funktionalität des zu veresternden Polyols ≥ 2 ist, können zusätzlich auch Monocarbonsäuren, wie Benzoesäure und Hexancarbonsäure mit verwendet werden.

Bevorzugte Säuren sind aliphatische oder aromatische Säuren der vorstehend genannten Art. Besonders bevorzugt sind dabei Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure oder Hydroxystearinsäure oder Mischungen davon. Geeignete Lactone sind Caprolacton, Butyrolacton oder Homologe oder Mischungen davon. Bevorzugt ist dabei Caprolacton.

Ebenfalls können zur Herstellung der Polyisocyanat-Prepolymere B) Hydroxylgruppen aufweisende Polycarbonate, beispielsweise Polycarbonatpolyole, bevorzugt Polycarbonatdiole, eingesetzt werden. Beispielsweise können diese ein zahlenmittleres Molekulargewichten $M_n$ von 400 g/mol bis 8000 g/mol, bevorzugt von 600 g/mol bis 3000 g/mol eingesetzt werden. Diese können durch Reaktion von Kohlensäurederivaten, wie Diphenylcarbonat, Dimethylcarbonat oder Phosgen, mit Polyolen, bevorzugt Diolen, erhalten werden.

Beispiele hierfür geeigneter Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A oder lactonmodifizierte Diole der vorstehend genannten Art oder Mischungen davon.

Bevorzugt enthält dann die Diolkomponente dabei von 40 Gewichtsprozent bis 100 Gewichtsprozent Hexandiol, vorzugsweise 1,6-Hexandiol und/oder Hexandiolderivate. Solche Hexandiolderivate basieren auf Hexandiol und können neben endständigen OH-Gruppen Ester- oder Ethergruppen aufweisen. Derartige Derivate sind beispielsweise durch Reaktion von Hexandiol mit überschüssigem Caprolacton oder durch Veretherung von Hexandiol mit sich selbst zum Di- oder Trihexylenglykol erhältlich. Die Menge dieser und anderer Komponenten werden derart gewählt, dass die Summe 100 Gewichtsprozent nicht überschreitet, insbesondere 100 Gewichtsprozent ergibt.

Hydroxylgruppen aufweisende Polycarbonate, insbesondere Polycarbonatpolyole, sind bevorzugt linear gebaut.

Ebenfalls können zur Herstellung der Polyisocyanat-Prepolymere B) Polyetherpolyole eingesetzt werden. Beispielsweise eignen sich Polytetramethylenglykolpolyether wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden.

Bevorzugte Komponenten zur Herstellung der Polyisocyanat-Prepolymere B) sind Polypropylenglykol, Polytetramethylenglykolpolyether und Polycarbonatpolyole beziehungsweise deren Mischungen, wobei Polypropylenglykol besonders bevorzugt ist.

Dabei können polymere Polyole mit einem zahlenmittleren Molekulargewicht $M_n$ von 400 g/mol bis 8000 g/mol, bevorzugt von 400 g/mol bis 6000 g/mol und besonders bevorzugt von 600 g/mol bis 3000 g/mol eingesetzt werden. Diese weisen bevorzugt eine OH-Funktionalität von 1,5 bis 6, besonders bevorzugt von 1,8 bis 3, ganz besonders bevorzugt von 1,9 bis 2,1 auf.

Neben den genannten polymeren Polyolen können auch kurzkettige Polyole bei der Herstellung der Polyisocyanat-Prepolymere B) eingesetzt werden. Beispielsweise kann Ethylenglykol, Diethylenglykol, Triethylenglykol, 1,2-Propandiol, 1,3-Propandiol, 1,4-Butandiol, 1,3-Butylenglykol, Cyclohexandiol, 1,4-Cyclohexandimethanol, 1,6-Hexandiol, Neopentylglykol, Hydrochinondihydroxyethylether, Bisphenol A (2,2-Bis(4-hydroxyphenyl)propan), hydriertes Bisphenol A (2,2-Bis(4-hydroxycyclohexyl)propan), Trimethylolpropan, Trimethylolethan, Glycerin oder Pentaerythrit oder eine Mischung davon eingesetzt werden.

Geeignet sind auch Esterdiole des genannten Molekulargewichtsbereichs wie $\alpha$-Hydroxybutyl-$\epsilon$-hydroxy-capronsäureester, $\omega$-Hydroxyhexyl-$\gamma$-hydroxybuttersäureester, Adipinsäure-($\beta$-hydroxyethyl)ester oder Terephthalsäurebis($\beta$-hydroxyethyl)ester.

Ferner können zur Herstellung der Polyisocyanat-Prepolymere B) auch monofunktionelle isocyanatreaktive hydroxylgruppenhaltige Verbindungen eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmonopropylether, Propylenglykolmonobutylether, Dipropylenglykohnonobutylether, Tripropylenglykolmonobutylether, 2-Ethylhexanol, 1-Octanol, 1-Dodecanol oder 1-Hexadecanol oder Mischungen davon.

Zur Herstellung der Polyisocyanat-Prepolymere B) können vorzugsweise Diisocyanate mit den Polyolen bei einem Verhältnis der Isocyanatgruppen zu Hydroxylgruppen (NCO/OH-Verhältnis) von 2:1 bis 20:1, beispielsweise von 8:1, umgesetzt werden. Dabei können Urethan- und/oder Allophanatstrukturen gebildet werden. Ein Anteil an nicht umgesetzten Polyisocyanaten kann anschließend abgetrennt werden. Hierfür kann beispielsweise eine Dünnschichtdestillation verwendet, wobei restmonomerenarme Produkte mit Restmonomergehalten von beispielsweise $\leq$1 Gewichtsprozent, bevorzugt $\leq$0,5 Gewichtsprozent, besonders bevorzugt $\leq$0,1 Gewichtsprozent, erhalten werden. Die Reaktionstemperatur kann dabei von 20 °C bis 120 °C, bevorzugt von 60 °C bis 100 °C, betragen. Gegebenenfalls können während der Herstellung Stabilisatoren wie Benzoylchlorid, Isophthaloylchlorid, Dibutylphosphat, 3-Chlorpropionsäure oder Methyltosylat zugesetzt werden.

Weiterhin können $NH_2$- und/oder NH-funktionelle Komponenten zusätzlich zur Kettenverlängerung bei der Herstellung der Polyisocyanat-Prepolymere B) eingesetzt werden.

Geeignete Komponenten zur Kettenverlängerung sind organische Di- oder Polyamine. Beispielsweise können Ethylendiamin, 1,2- Diaminopropan, 1,3-Diaminopropan, 1,4-Diaminobutan, 1,6-Diaminohexan, Isophorondiamin, Isomerengemische von 2,2,4- und 2,4,4-Trimethylhexamethylendiamin, 2-Methylpentamethylendiamin, Diethylentriamin, Diaminodicyclohexylmethan oder Dimethylethylendiamin oder Mischungen davon eingesetzt werden.

Darüber hinaus können auch Verbindungen, die neben einer primären Aminogruppe auch sekundäre Aminogruppen oder neben einer Aminogruppe (primär oder sekundär) auch OH-Gruppen aufweisen, zur Herstellung der Polyisocyanat-Prepolymere B) eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3 -Amino-1 -methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Die als Komponente B) eingesetzten Polyisocyanat-Prepolymere oder deren Mischungen können bevorzugt eine mittlere NCO-Funktionalität von 1,8 bis 5, besonders bevorzugt 2 bis 3,5 und ganz besonders bevorzugt 2 bis 3 aufweisen.

Die Komponente C) ist eine Verbindung mit mindestens zwei isocyanatreaktiven funktionellen Gruppen. Beispielsweise kann Komponente C) ein Polyamin oder ein Polyol mit mindestens zwei isocyanatreaktiven Hydroxygruppen sein.

Als Komponente C) können hydroxyfunktionelle, insbesondere polymere, Polyole, beispielsweise Polyetherpolyole oder Polyesterpolyole eingesetzt werden. Geeignete Polyole wurden bereits vorstehend im Zusammenhang mit der Herstellung des Prepolymers B) geschildert, so dass zur Vermeidung von Wiederholungen hierauf Bezug genommen wird.

Es ist bevorzugt, dass die Komponente C) ein Polymer mit 2 bis 4 Hydroxygruppen pro Molekül, ganz besonders bevorzugt ein Polypropylenglykol mit 2 bis 3 Hydroxygruppen pro Molekül ist.

Es ist günstig, wenn die polymeren Polyole C) eine besonders enge Molekulargewichtsverteilung, das heißt eine Polydispersität (PD = Mw/Mn) von 1,0 bis 1,5 aufweisen. Bevorzugt weisen beispielsweise Polyetherpolyole eine Polydispersität von 1,0 bis 1,5 und eine OH-Funktionalität von größer 1,9 auf, und besonders bevorzugt größer oder gleich 1,95 auf.

Solche Polyetherpolyole sind in an sich bekannter Weise durch Alkoxylierung von geeigneten Starter-Molekülen, insbesondere unter Verwendung von Doppelmetallcyanid-Katalysatoren (DMC-Katalyse) herstellbar. Diese Methode ist zum Beispiel in der Patentschrift US 5,158,922 und der Offenlegungsschrift EP 0 654 302 A1 beschrieben.

Die Reaktionsmischung für das Polyurethan kann durch Mischen der Komponenten A) und/oder B) und C) erhalten werden. Das Verhältnis von isocyanatreaktiven Hydroxygruppen zu freien Isocyanatgruppen ist dabei vorzugsweise von 1:1,5 bis 1,5:1 besonders bevorzugt von 1:1,02 bis 1:0,95.

Vorzugsweise besitzt zumindest eine der Komponenten A), B) oder C) eine Funktionalität von $\geq 2,0$, bevorzugt von $\geq 2,5$ bevorzugt von $\geq 3,0$, um in das Polymerelement eine Verzweigung oder eine Vernetzung einzuführen. Der Begriff "Funktionalität" bezieht sich bei Komponente A) und B) auf die mittlere Anzahl von NCO-Gruppen pro Molekül und bei Komponente C) auf die mittlere Anzahl von OH-Gruppen pro Molekül. Diese Verzweigung beziehungsweise Vernetzung bewirkt bessere mechanische Eigenschaften und bessere elastomere Eigenschaften, insbesondere auch bessere Dehnungseigenschaften. Das erhaltene Polyurethanpolymer kann vorzugsweise eine maximale Spannung von $\geq 0,2$ MPa, insbesondere von 0,4 MPa bis 50 MPa, und eine maximale Dehnung von $\geq 100$ %, insbesondere von $\geq 120$ %, aufweisen. Darüber hinaus kann das Polyurethan im Gebrauchsdehnungsbereich bis $\leq 200$ % eine Spannung von 0,1 MPa bis 50 MPa, beispielsweise von 0,5 MPa bis 40 MPa, insbesondere von 1 MPa bis 30 MPa, aufweisen (Bestimmung nach ASTM D 412). Ferner kann das Polyurethan ein Elastizitätsmodul bei einer Dehnung von 100 % von 0,1 MPa bis 100 MPa, beispielsweise von 1 MPa bis 80 MPa, aufweisen (Bestimmung nach ASTM D 412).

Vorzugsweise ist das erhaltene Polyurethanpolymer ein dielektrisches Elastomer mit einem spezifischen elektrischen Volumenwiderstand gemäß ASTM D 257 von $\geq 10^{12}$ bis $\leq 10^{17}$ Ohm cm. Es ist weiterhin bevorzugt, dass das Polyurethanpolymer eine dielektrische Durchbruchsfeldstärke gemäß ASTM 149-97a von $\geq 50$ V/$\mu$m bis $\leq 200$ V/$\mu$m aufweist.

Die Reaktionsmischung zur Herstellung des Polyurethans kann neben den Komponenten A), B), C) und D) zusätzlich auch Hilfs- und Zusatzstoffe enthalten. Beispiele für solche Hilfs- und Zusatzstoffe sind Vernetzer, Verdicker, Lösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel. Bevorzugte Lösungsmittel sind Methoxypropylacetat und Ethoxypropylacetat. Bevorzugte Verlaufshilfsmittel sind Polyacrylate, insbesondere aminharzmodifizierte Acrylcopolymerisate.

Füllstoffe können beispielsweise die Dielektrizitätskonstante des Polymerelements regulieren. Vorzugsweise umfasst die Reaktionsmischung Füllstoffe zur Erhöhung der Dielektrizitätskonstanten wie Füllstoffe mit einer hohen Dielektrizitätskonstante. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb der Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Angemerkt sei, dass die Begriffe "ein" und "eine" im Zusammenhang mit der vorliegenden Erfindung und insbesondere mit den Komponenten A), B) und C) nicht als Zahlwörter, sondern als unbestimmter Artikel verwendet werden, sofern der Kontext nicht eindeutig eine andere Aussage ergibt.

In einer weiteren Ausführungsform des erfindungsgemäßen elektromechanischen Wandlers weist das Material der dielektrischen Elastomerschicht eine dielektrische Konstante $\varepsilon_r$ von $\geq 2$ auf. Diese dielektrische Konstante kann auch in einem Bereich von $\geq 2$ bis $\leq 2000$ oder von $\geq 3$ bis $\leq 1000$ liegen. Die Bestimmung dieser Konstante kann gemäß ASTM 150-98 erfolgen.

In einer weiteren Ausführungsform des erfindungsgemäßen elektromechanischen Wandlers umfasst wenigstens eine Elektretschicht ein Polymer, das ausgewählt ist aus der Gruppe umfassend Polycarbonate, perfluorierte oder teilfluorierte Polymere und Co-Polymere, Polytetrafluorethylen (PTFE), Fluorethylenpropylen (FEP), Perfluoralkoxyethylen (PFA), Polyester, Polyethylenterephthalat (PET), Polyethylennaphthalat (PEN), Polyimid, Polyetherimid, Polyether, Polymethyl (meth)acrylat, Cyclo-Olefin-Polymere, Cyclo-Olefin-Copolymere (COC), Polyolefine, Polypropylen und Mischungen dieser Polymere. Falls mehr als eine Elektretschicht vorhanden sind, gilt dieses entsprechend auch für diese Schicht. Bevorzugtes Material ist hierbei FEP.

In einer weiteren Ausführungsform des erfindungsgemäßen elektromechanischen Wandlers ist das Material mindestens der ersten Elektrode ausgewählt aus der Gruppe umfassend Metalle, Metalllegierungen, leitfähige Oligo- oder Polymere, leitfähige Oxide und/oder mit leitfähigen Füllstoffen gefüllten Polymeren. Falls eine zweite Elektrode vorhanden ist, gilt dieses entsprechend auch für sie. Als leitfähige Oligo- oder Polymere können beispielsweise Polythiophene, Polyaniline oder Polypyrrole eingesetzt werden. Als Füllstoffe für mit leitfähigen Füllstoffen gefüllte Polymere können beispielsweise Metalle, leitfähige Kohlenstoff basierte Materialien, wie Ruß, Kohlenstoff-Nanoröhrchen (carbon nanotubes, CNT) oder leitfähige Oligo- oder Polymere eingesetzt werden. Der Füllstoffgehalt der Polymere liegt dabei vorzugsweise oberhalb der Perkolationsschwelle, so dass die leitfähigen Füllstoffe durchgehend elektrisch leitfähige Pfade innerhalb der mit leitfähigen Füllstoffen gefüllten Polymere ausbilden.

In einer weiteren Ausführungsform des erfindungsgemäßen elektromechanischen Wandlers liegt das Dickenverhältnis zwischen dielektrischer Elastomerschicht und der wenigstens einen Elektretschicht in einem Bereich von ≥ 1:1 bis≤ 100:1. Die Dickenverhältnisse sind jeweils für die Dicke der Elastomerschicht und einer Elektretschicht angegeben und können auch in einem Bereich von ≥ 2:1 bis ≤ 50:1 liegen.

Die vorliegende Erfindung betrifft weiterhin ein Verfahren zur Herstellung eines erfindungsgemäßen elektromechanischen Wandlers, umfassend die Schritte:

(a1) Bereitstellen einer dielektrischen Elastomerschicht;

(b1) Kontaktieren der dielektrischen Elastomerschicht mit einer ersten Elektretschicht;

(c1) Elektrisches Aufladen der zuvor erhaltenen Anordnung, so dass die erste Elektretschicht eine elektrische Ladung trägt;

(d1) Kontaktieren der ersten Elektretschicht mit einer ersten Elektrode; und

(e1) Anordnen einer zweiten Elektrode auf der der ersten Elektrode gegenüberliegenden Seite der dielektrischen Elastomerschicht.

In diesem erfindungsgemäßen Verfahren ist die Reihenfolge der Schritte und insbesondere der Schritte (b1) und (c1) nicht von vorneherein festgelegt. Es ist zum Beispiel auch möglich, dass nach (c1 zunächst (b1) und dann (d1) und (e1) durchgeführt werden.

Das Bereitstellen der dielektrischen Elastomerschicht kann zweckmäßigerweise direkt von einer Rolle erfolgen, so dass ein "roll-to-roll"-Prozess ermöglicht wird. Aus denselben Überlegungen heraus kann dieses auch für die Elektretschichten durchgeführt werden.

Das Kontaktieren der Elastomerschicht mit den Elektretschichten lässt sich beispielsweise durch Auflaminieren bei erhöhten Temperaturen erreichen. Auf diese Weise kann eine feste Verbindung zwischen den einzelnen Schichten aufgebaut werden.

Alternativ können bei den zuvor beschriebenen Schritten auch Lösungsmittel-basierte oder Extrusions- und Coextrusionsverfahren zum Einsatz kommen.

Die beiden Elektretschichten werden so aufgeladen, dass sie einander entgegengesetzte elektrische Ladungen tragen. Dieses kann beispielsweise mittels Triboaufladung, Elektronenstrahlbeschuss, Anlegen einer elektrischen Spannung an bereits vorhandene Elektroden oder Coronaentladung erfolgen. Insbesondere kann das Aufladen durch eine Zweielektronen-Corona-Anordnung erfolgen. Dabei kann die Nadelspannung ≥ 20 kV, ≥ 25 kV und insbesondere ≥ 30 kV betragen. Die Aufladezeit kann dabei ≥ 20 s, ≥25 s und insbesondere ≥30 s betragen. Eine Corona-Behandlung ist vorteilhafterweise auch im großtechnischen Maßstab gut einsetzbar.

Die Elektretschichten können mit den Elektroden mittels üblicher Verfahren wie Sputtern, Sprühen, Aufdampfen, chemische Gasphasenabscheidung (CVD), Drucken, Rakeln und Spincoating kontaktiert werden.

Beim Anordnen der zweiten Elektrode auf der der ersten Elektrode gegenüberliegenden Seite der dielektrischen Elastomerschicht kann grundsätzlich ebenso vorgegangen werden. Es ist möglich, dass die Elastomerschicht mit der zweiten Elektrode kontaktiert wird. Es ist aber auch möglich, dass sich zwischen der zweiten Elektrode und der Elastomerschicht beispielsweise noch eine Elektretschicht befindet, die dann entsprechend kontaktiert wird.

Ein weiterer Gegenstand der vorliegenden Erfindung ist die Verwendung eines erfindungsgemäßen elektromechanischen Wandlers als Aktor, Sensor oder Generator. Die Verwendung kann beispielsweise im elektromechanischen und/oder elektroakustischen Bereich erfolgen. Insbesondere können erfindungsgemäße elektromechanische Wandler im Bereich der Energiegewinnung aus mechanischen Schwingungen ("energy harvesting"), der Akustik, des Ultraschalls, der medizinischen Diagnostik, der akustischen Mikroskopie, der mechanischen Sensorik, insbesondere Druck-, Kraft- und/ oder Dehnungssensorik, der Robotik und/oder der Kommunikationstechnologie, insbesondere in Lautsprechern, Schwingungswandlern, Lichtdeflektoren, Membranen, Modulatoren für Glasfaseroptik, pyroelektrischen Detektoren, Kondensatoren und Kontrollsystemen verwendet werden.

Die vorliegende Erfindung betrifft ebenfalls einen Aktor, Sensor oder Generator, umfassend einen erfindungsgemäßen elektromechanischen Wandler. Zur Vermeidung unnötiger Längen wird hinsichtlich Details und spezieller Ausführungsformen auf die obigen Ausführungen zum Wandler verwiesen.

Ebenfalls im Rahmen der vorliegenden Erfindung vorgesehen ist ein Verfahren zur Gewinnung von elektrischer Energie, umfassend die Schritte:

(a2) Bereitstellen eines Generatorelements, wobei das Generatorelement eine Längsrichtung und eine Dickenrichtung aufweist und mindestens eine in Längsrichtung angeordnete Elektretschicht oder mehrere in Längsrichtung angeordnete, sich gegenüberliegende Elektretschichten umfasst, wobei innerhalb einer Elektretschicht in Dickenrichtung des Generatorelements eine elektrische Ladungstrennung herrscht und diese Elektretschicht auf in Dickenrichtung gegenüberliegenden Seiten von Elektroden kontaktiert ist oder

wobei eine Elektretschicht eine elektrische Ladung trägt und diese Elektretschicht auf in Dickenrichtung gegenüberliegenden Seiten von Elektroden kontaktiert ist oder

wobei eine Elektretschicht eine elektrische Ladung trägt und eine weitere Elektretschicht eine hiervon verschiedene oder gleiche elektrische Ladung trägt und diese Elektretschichten jeweils von einer Elektrode kontaktiert sind;

(b2) Dehnen des Generatorelements entlang der Längsrichtung und Ableiten von elektrischer Ladung von den Elektroden; und

(c2) Relaxieren des Generatorelements entlang der Längsrichtung und Ableiten von elektrischer Ladung von den Elektroden.

Das erfindungsgemäße Verfahren zur Gewinnung von elektrischer Energie geht von der Erkenntnis aus, dass ein Generatorelement im planaren Modus ($d_{31}$-Mode) betrieben wird. Im einfachsten Fall ist das Generatorelement eine ausreichend dicke Elektretschicht, in der eine makroskopische elektrische Ladungstrennung entlang ihrer Dicke herrscht und die mittels Elektroden mit einer geeigneten elektrischen Schaltung verbunden werden kann. Es ist ebenfalls möglich, dass eine elektrisch geladene, beidseitig mit Elektroden kontaktierte Elektretschicht vorhanden ist.

Ein weiterer einfacher Fall ist, dass zwei gleich oder unterschiedlich geladene und räumlich getrennte, übereinanderliegende Elektretschichten vorliegen.

Das Generatorelement wird entlang seiner Längsrichtung gedehnt. Hierbei kann auch allgemein in der Flächenrichtung gedehnt werden. Beim Dehnen ändert sich vorzugsweise der Abstand der Elektroden zueinander, wodurch es bei einem asymmetrischen Aufbau des Generators zu einer Ladungsverschiebung kommt. Es ist jedoch auch gerade für den symmetrischen Fall möglich, dass sich die Fläche von sich gegenüberliegenden Elektretschichten ändert und dieses zu einer dielektrischen Verschiebung führt. Die resultierende elektrische Spannung wird von den Elektroden abgeleitet und kann genutzt werden. Beim Relaxieren des Generatorelements findet der umgekehrte Vorgang statt.

In einer Ausführungsform dieses erfindungsgemäßen Verfahrens ist das Generatorelement ein wie zuvor beschriebener erfindungsgemäßer elektromechanischer Wandler. Zur Vermeidung unnötiger Längen wird hinsichtlich Details und spezieller Ausführungsformen auf die obigen Ausführungen zum Wandler verwiesen.

Die Erfindung wird anhand der nachfolgenden Zeichnungen weiter erläutert, ohne jedoch darauf beschränkt zu sein. Es zeigen:

FIG. 1 einen elektromechanischen Wandler

FIG. 2 einen weiteren elektromechanischen Wandler

FIG. 3 einen weiteren elektromechanischen Wandler

FIG. 4 einen weiteren elektromechanischen Wandler

FIG. 5 einen weiteren elektromechanischen Wandler

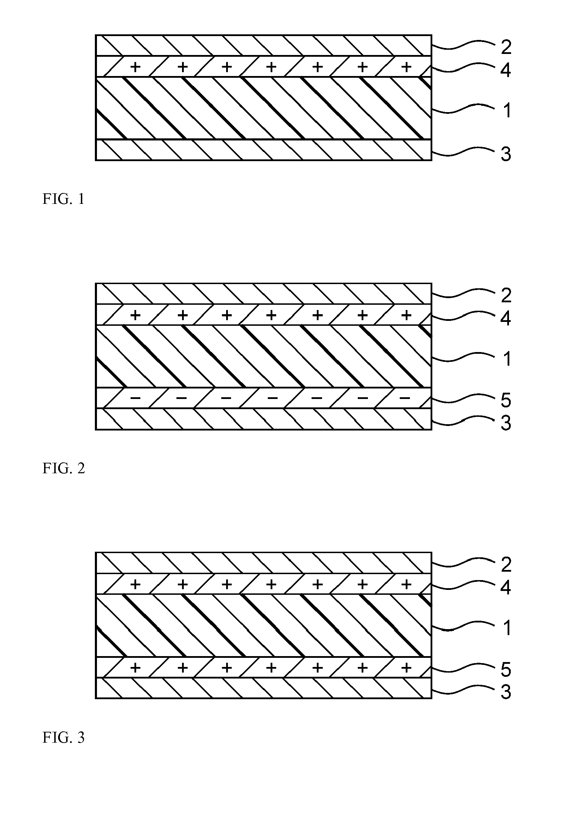

FIG. 1 zeigt einen elektromechanischen Wandler in Querschnittsansicht. Es kann sich um die Querschnittsansicht eines Laminatfilms handeln. Die Dickenrichtung dieser Anordnung verläuft in der Zeichnung vertikal und die Längsrichtung horizontal.

Eine dielektrische Elastomerschicht 1 ist auf ihrer Oberseite von einer ersten Elektretschicht 4 kontaktiert. Schematisch dargestellt durch das Symbole "+" ist die elektrische Ladung dieser Elektretschichten. Dieses kann während der Herstellung des Wandlers in einem Coronaentladungsverfahren erreicht werden. Auf der der dielektrischen Elastomerschicht 1 abgewandten Seite der Elektretschicht 4 ist die erste Elektrode 2 angeordnet. Die zweite Elektrode 3 befindet sich auf der der Elektretschicht 4 abgewandten Seite der dielektrischen Elastomerschicht.

Bei einer Dehnung des Wandlers in Längsrichtung kommt es zu einer Verringerung der Dicke. Dadurch, dass der Abstand zwischen der Elektretschicht 4 und der ersten Elektrode 2 beim Dehnen konstant bleibt, aber der Abstand dieser Elektretschicht 4 zur zweiten Elektrode 3 sich ändert, tritt ein piezoelektrischer Effekt auf. Die dabei auftretende elektrische Spannung lässt sich mittels der Elektroden 2 und 3 abgreifen.

In FIG. 2 ist ein weiterer elektromechanischer Wandler in Querschnittsansicht dargestellt. Beispielsweise kann es sich auch hier um die Querschnittsansicht eines Laminatfilms handeln. Die Dickenrichtung dieser Anordnung verläuft in der Zeichnung vertikal und die Längsrichtung horizontal.

Eine dielektrische Elastomerschicht 1 ist auf ihrer Oberseite und auf der gegenüberliegenden Unterseite von erster Elektretschicht 4 und zweiter Elektretschicht 5 kontaktiert. Schematisch dargestellt durch die Symbole "+" und "-" sind die entgegengesetzten elektrischen Ladungen der beiden Elektretschichten 4, 5. Dieses kann während der Herstellung des Wandlers in einem Coronaentladungsverfahren mittels geeigneter Positionierung der Elektroden erreicht werden.

Durch die Lage der Elektretschichten 4, 5 werden jeweils der dielektrischen Elastomerschicht 1 zugewandte und abgewandte Seiten der Elektretschichten 4, 5 gebildet. Auf der der Elastomerschicht 1 abgewandten Seite der ersten Elektretschicht 4 befindet sich die erste Elektrode 2. Entsprechend befindet sich auf der der Elastomerschicht 1 abgewandten Seite der zweiten Elektretschicht 5 die zweite Elektrode 3.

Bei einer Dehnung des Wandlers in Längsrichtung kommt es zu einer Kontraktion in Dickenrichtung. Dieses hat eine Annäherung der entgegengesetzt geladenen Elektretschichten 4 und 5 zur Folge. Bei einer Relaxation in Längsrichtung entfernen sich die Elektretschichten 4 und 5 wieder voneinander. Die aufgrund des piezoelektrischen Effekts auftretende elektrische Spannung lässt sich mittels der Elektroden 2 und 3 abgreifen.

FIG. 3 zeigt eine Variation des in FIG. 2 dargestellten elektromechanischen Wandlers. Die beiden Elektretschichten 4, 5 weisen nun dieselbe, positive elektrische Ladung auf. Selbstverständlich können diese Schichten auch beide negativ geladen sein. Bei einer Dehnung des Wandlers in Längsrichtung kommt es auch hier aufgrund der Änderung in der Größe der sich gegenüberliegenden Flächen zu einem piezoelektrischen Effekt.

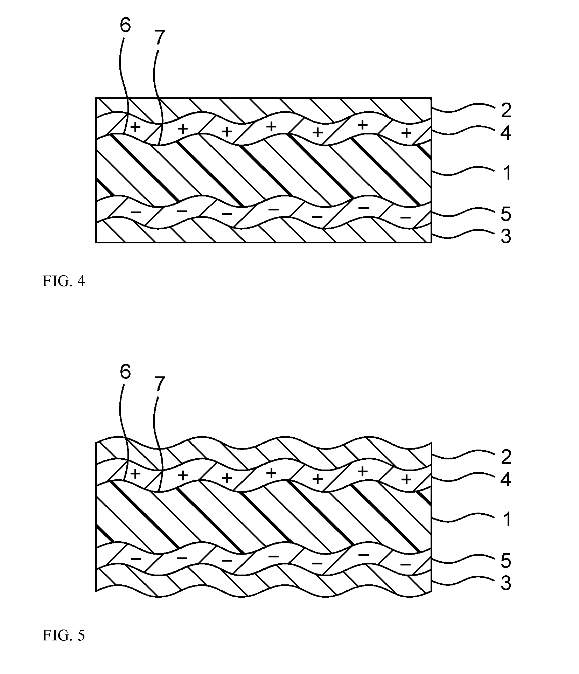

FIG. 4 zeigt eine weitere Variation des in FIG. 2 dargestellten elektromechanischen Wandlers. Hierbei weist nun die dielektrische Elastomerschicht 1 entlang der Längsrichtung ein wellenförmiges Querschnittsprofil auf. Im vorliegenden Fall ist der wellenförmige Querschnitt an von beiden Elektretschichten 4, 5 kontaktierten Seiten der Elastomerschicht 1 ausgebildet. Das wellenförmige Querschnittsprofil weist Erhebungen 6 und Vertiefungen 7 auf. Die Erhebungen 6 und Vertiefungen 7 der Ober- und der Unterseite der Elastomerschicht 1 verlaufen hier parallel. Dieses hat den Vorteil, dass bei einer großen Dehnung in Längsrichtung die Dicke der Elastomerschicht 1 im Verlauf der Längsrichtung möglichst einheitlich bleibt.

Die Elektretschichten 4, 5 weisen ebenfalls jeweils beidseitig ein wellenförmiges Querschnittsprofil auf, welches an das Profil der Elastomerschicht 1 angepasst ist. Auch hier ist das Verhalten bei großen Dehnungen in Längsrichtung vorteilhaft. Die die Elektretschichten 4, 5 kontaktierenden Seiten der Elektroden 2, 3 sind in ihrem Querschnittsprofil dem wellenförmigen Profil der Elektretschichten 4, 5 angepasst.

FIG. 5 zeigt eine Variation des in FIG. 4 dargestellten elektromechanischen Wandlers. Die die Elektretschichten 4, 5 kontaktierenden Elektroden 2, 3 weisen nun an ihren jeweiligen Ober- und Unterseiten ein an as der Elektretschichten 4, 5 angepasstes wellenförmiges Profil auf. Hier ist das Querschnittsprofil des gesamten Wandlers auf das Dickenverhalten bei hohen Dehnungen hin optimiert worden.

**Patentansprüche**

1. Elektromechanischer Wandler,
   **dadurch gekennzeichnet, dass**
   der Wandler mindestens eine dielektrische Elastomerschicht (1), Elektroden (2, 3) sowie mindestens eine Elektretschicht (4, 5) umfasst,
   wobei die dielektrische Elastomerschicht (1) von der wenigstens einen Elektretschicht (4) kontaktiert wird,
   wobei die wenigstens eine Elektretschicht (4) eine elektrische Ladung trägt und von einer ersten Elektrode (2) kontaktiert wird und
   wobei auf der der ersten Elektrode (2) gegenüberliegenden Seite der dielektrischen Elastomerschicht (1) eine zweite Elektrode (3) angeordnet ist.

2. Elektromechanischer Wandler gemäß Anspruch 1,
   **dadurch gekennzeichnet, dass**
   die dielektrische Elastomerschicht (1) auf sich gegenüberliegenden Seiten von einer ersten Elektretschicht (4) und einer zweiten Elektretschicht (5) kontaktiert ist,
   wobei die erste Elektretschicht (4) und die zweite Elektretschicht (5) einander entgegengesetzte elektrische Ladungen tragen und
   wobei die erste Elektretschicht (4) von der ersten Elektrode (2) und die zweite Elektretschicht (5) von der zweiten Elektrode (3) kontaktiert werden.

3. Elektromechanischer Wandler gemäß Anspruch 1 oder 2,
   **dadurch gekennzeichnet, dass**
   wenigstens eine der Seiten der dielektrischen Elastomerschicht (1) entlang wenigstens einer Richtung ein wellenförmiges Querschnittsprofil mit Erhebungen (6) und Vertiefungen (7) aufweist.

4. Elektromechanischer Wandler gemäß Anspruch 3,
   **dadurch gekennzeichnet, dass**
   die von der wenigstens einen Elektretschicht (4) kontaktierte Seite und die dieser Seite gegenüberliegende Seite der dielektrischen Elastomerschicht (1) entlang derselben Richtung ein wellenförmiges Querschnittsprofil mit Erhebungen (6) und Vertiefungen (7) aufweisen und wobei weiterhin Erhebungen (6) und Vertiefungen (7) des Profils der einen Seite parallel zu Erhebungen (6) und Vertiefungen (7) des Profils der anderen Seite der dielektrischen Elastomerschicht (1) verlaufen.

5. Elektromechanischer Wandler gemäß Anspruch 3,
   **dadurch gekennzeichnet, dass**
   die wenigstens eine Elektretschicht (4) und/oder mindestens die erste Elektrode (2) entlang wenigstens einer Richtung ein wellenförmiges Querschnittsprofil aufweisen, welches an das wellenförmige Querschnittsprofil der kontaktierten Seite der dielektrischen Elastomerschicht (1) angepasst ist.

6. Elektromechanischer Wandler nach einem der Ansprüche 1 bis 5,
   **dadurch gekennzeichnet, dass**
   die dielektrische Elastomerschicht (1) ein Polyurethanpolymer, Silikonpolymer und/oder Acrylatpolymer umfasst.

7.  Elektromechanischer Wandler nach einem der Ansprüche 1 bis 6,
    **dadurch gekennzeichnet, dass**
    das Material der dielektrischen Elastomerschicht (1) eine dielektrische Konstante $\varepsilon_r$ von $\geq 2$ aufweist.

8.  Elektromechanischer Wandler nach einem der Ansprüche 1 bis 7,
    **dadurch gekennzeichnet, dass**
    wenigstens eine Elektretschicht (4) ein Polymer umfasst, das ausgewählt ist aus der Gruppe umfassend Polycarbonate, perfluorierte oder teilfluorierte Polymere und Co-Polymere, Polytetrafluorethylen (PTFE), Fluorethylenpropylen (FEP), Perfluoralkoxyethylen (PFA), Polyester, Polyethylenterephthalat (PET), Polyethylennaphthalat (PEN), Polyimid, Polyetherimid, Polyether, Polymethyl(meth)acrylat, Cyclo-Olefin-Polymere, Cyclo-Olefin-Copolymere (COC), Polyolefine, Polypropylen und Mischungen dieser Polymere.

9.  Elektromechanischer Wandler nach einem der Ansprüche 1 bis 8,
    **dadurch gekennzeichnet, dass**
    das Material mindestens der ersten Elektrode (2) ausgewählt ist aus der Gruppe umfassend Metalle, Metalllegierungen, leitfähige Oligo- oder Polymere, leitfähige Oxide und/oder mit leitfähigen Füllstoffen gefüllten Polymeren.

10. Elektromechanischer Wandler nach einem der Ansprüche 1 bis 9,
    **dadurch gekennzeichnet, dass**
    das Dickenverhältnis zwischen dielektrischer Elastomerschicht (1) und der wenigstens einen Elektretschicht (4) in einem Bereich von $\geq 1{:}1$ bis $\leq 100{:}1$ liegt.

11. Verfahren zur Herstellung eines elektromechanischen Wandlers gemäß einem der Ansprüche 1 bis 10, umfassend die Schritte:

    (a1) Bereitstellen einer dielektrischen Elastomerschicht (1);
    (b1) Kontaktieren der dielektrischen Elastomerschicht (1) mit einer ersten Elektretschicht (4);
    (c1) Elektrisches Aufladen der zuvor erhaltenen Anordnung, so dass die erste Elektretschicht (4) eine elektrische Ladungen trägt;
    (d1) Kontaktieren der ersten Elektretschicht (4) mit einer ersten Elektrode (2); und
    (e1) Anordnen einer zweiten Elektrode auf der der ersten Elektrode (2) gegenüberliegenden Seite der dielektrischen Elastomerschicht (1).

12. Verwendung eines elektromechanischen Wandlers gemäß einem der Ansprüche 1 bis 10 als Aktor, Sensor oder Generator.

13. Aktor, Sensor oder Generator, umfassend einen elektromechanischen Wandler gemäß einem der Ansprüche 1 bis 10.

14. Verfahren zur Gewinnung von elektrischer Energie, umfassend die Schritte:

    (a2) Bereitstellen eines Generatorelements, wobei das Generatorelement eine Längsrichtung und eine Dickenrichtung aufweist und mindestens eine in Längsrichtung angeordnete Elektretschicht oder mehrere in Längsrichtung angeordnete, sich gegenüberliegende Elektretschichten umfasst,
    wobei innerhalb einer Elektretschicht in Dickenrichtung des Generatorelements eine elektrische Ladungstrennung herrscht und diese Elektretschicht auf in Dikkenrichtung gegenüberliegenden Seiten von Elektroden kontaktiert ist oder
    wobei eine Elektretschicht eine elektrische Ladung trägt und diese Elektretschicht auf in Dikkenrichtung gegenüberliegenden Seiten von Elektroden kontaktiert ist oder
    wobei eine Elektretschicht eine elektrische Ladung trägt und eine weitere Elektretschicht eine hiervon verschiedene oder gleiche elektrische Ladung trägt und diese Elektretschichten jeweils von einer Elektrode kontaktiert sind;
    (b2) Dehnen des Generatorelements entlang der Längsrichtung und Ableiten von elektrischer Ladung von den Elektroden; und
    (c2) Relaxieren des Generatorelements entlang der Längsrichtung und Ableiten von elektrischer Ladung von den Elektroden.

15. Verfahren gemäß Anspruch 14,
    **dadurch gekennzeichnet, dass**
    das Generatorelement ein elektromechanischer Wandler gemäß einem der Ansprüche 1 bis 10 ist.

FIG. 1

FIG. 2

FIG. 3

FIG. 4

FIG. 5

Europäisches
Patentamt

European
Patent Office

Office européen
des brevets

**EUROPÄISCHER RECHERCHENBERICHT**

Nummer der Anmeldung

EP 10 16 7012

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 159 857 A1 (BAYER MATERIALSCIENCE AG) 3. März 2010 (2010-03-03) | 1,2,6-13 | INV. H01L41/08 |
| Y | * Absätze [0011] - [0016], [0021], [0022], [0031], [0038], [0041], [0053] - [0055]; Abbildung 1 * | 3-5 | H01L41/26 H01L41/113 H01L41/193 |
| | ----- | | |
| X | KACPRZYK R ET AL: "Piezoelectric properties of nonuniform electrets", JOURNAL OF ELECTROSTATICS, Bd. 35, Nr. 2-3, 1995, Seiten 161-166, XP004040896, ISSN: 0304-3886 * Zusammenfassung * * Abschnitte 2, 3;Abbildung 1 * | 1,6-10, 12,13 | |
| | ----- | | |
| X | DE 28 29 225 A1 (LEWINER JACQUES; HENNION CLAUDE) 18. Januar 1979 (1979-01-18) * Seiten 10-16; Abbildungen 2, 3 * | 1,6-10, 12,13 | |
| | ----- | | |
| Y,D | US 2009/169829 A1 (BENSLIMANE MOHAMED YAHIA ET AL) 2. Juli 2009 (2009-07-02) * Absätze [0092] - [0112]; Abbildungen 1-4 * | 3-5 | RECHERCHIERTE SACHGEBIETE (IPC) H01L H02N H04R |
| | ----- | | |

Der vorliegende Recherchenbericht wurde für alle Patentansprüche erstellt

| Recherchenort | Abschlußdatum der Recherche | Prüfer |
|---|---|---|
| München | 10. Dezember 2010 | Köpf, Christian |

EPO FORM 1503 03.82 (P04C03)

Europäisches
Patentamt

European
Patent Office

Office européen
des brevets

**Nummer der Anmeldung**

EP 10 16 7012

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☐ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

1-13

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

Nummer der Anmeldung

EP 10 16 7012

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-13

   Elektromechanischer Wandler mit mindestens einer dielektrischen Elastomerschicht, die von wenigstens einer Elektretschicht kontaktiert wird, wobei die wenigstens eine Elektretschicht von einer ersten Elektrode kontaktiert wird und auf der der ersten Elektrode gegenüberliegenden Seite der dielektrischen Elastomerschicht eine zweite Elektrode angeordnet ist, sowie Verfahren zur Herstellung des Wandlers
   - - -

2. Ansprüche: 14, 15

   Verfahren zur Gewinnung von elektrischer Energie mittels eines Generatorelements umfassend mindestens eine in Längsrichtung angeordnete Elektretschicht und Elektroden, wobei innerhalb der mindestens einen Elektretschicht in Dickenrichtung eine elektrische Ladungstrennung herrscht oder die mindestens eine Elektretschicht eine elektrische Ladung trägt, durch Dehnen und Relaxieren des Generatorelements entlang der Längsrichtung und Ableiten von elektrischer Ladung von den Elektroden
   - - -

**EP 2 400 573 A1**

**ANHANG ZUM EUROPÄISCHEN RECHERCHENBERICHT**
**ÜBER DIE EUROPÄISCHE PATENTANMELDUNG NR.**

EP 10 16 7012

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-12-2010

| Im Recherchenbericht angeführtes Patentdokument | Datum der Veröffentlichung | Mitglied(er) der Patentfamilie | Datum der Veröffentlichung |
|---|---|---|---|
| EP 2159857 A1 | 03-03-2010 | WO 2010022896 A1 | 04-03-2010 |
| DE 2829225 A1 | 18-01-1979 | BE 868729 A1 | 04-01-1979 |
| | | CA 1118090 A1 | 09-02-1982 |
| | | CH 624523 A5 | 31-07-1981 |
| | | FR 2397120 A1 | 02-02-1979 |
| | | GB 2013032 A | 01-08-1979 |
| | | IT 1103644 B | 14-10-1985 |
| | | JP 54014696 A | 03-02-1979 |
| | | NL 7807245 A | 08-01-1979 |
| | | SE 7807402 A | 05-01-1979 |
| | | US 4250415 A | 10-02-1981 |
| US 2009169829 A1 | 02-07-2009 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 200106575 A1
- US 20090169829 A1
- WO 2008076271 A2
- US 5158922 A
- EP 0654302 A1

**In der Beschreibung aufgeführte Nicht-Patentliteratur**

- **VON H. C. BASSO ; R. A. P. ALTAFIM ; R. A. C. ALTAFIM ; A. MELLINGER ; PENG FANG ; W. WIRGES ; R. GERHARD.** Three-layer ferroelectrets from perforated Teflon®-PFTE films fused between two homogenous Teflon®-FEP films. *Annual Report Conference on Electrical Insulation and Dielectric Phenomena,* 2007